# EUROPÄISCHE PATENTANMELDUNG

(11) **EP 2 157 839 A1**
(43) Veröffentlichungstag der Anmeldung: **24.02.2010**
(21) Anmeldenummer: 08014721.8
(22) Anmeldetag: 19.08.2008
(51) Int. Cl.: H05K 1/11

(54) **Leiterplatte**

(71) Anmelder: Siemens Aktiengesellschaft, 80333 München (DE)
(72) Erfinder: Chowaniec, Michael, 09126 Chemnitz (DE); Rohne, Klaus, 09350 Lichtenstein (DE)

(57) **Zusammenfassung**

Um bei einer Leiterplatte (20) mit zumindest einer ersten Leiterbahn (21), mit einer flächig ausgebildeten Unterseite (3a), einer flächig ausgebildeten Oberseite (1a), wobei ein erstes Verbindungsmittel zur Herstellung einer Verbindung zu einem lösbaren Steckmittel mit der ersten Leiterbahn (21) in Verbindung steht, eine Packungsdichte von Kontakten für das Steckmittel zu erhöhen, wird vorgeschlagen, dass weitere Verbindungsmittel in einer Aussparung (10) zwischen der Oberseite (1a) und der Unterseite (3a) der Leiterplatte (20) angeordnet sind.

## Beschreibung

Die Erfindung betrifft eine Leiterplatte mit zumindest einer ersten Leiterbahn, einer flächig ausgebildeten Unterseite, einer flächig ausgebildeten Oberseite, wobei ein erstes Verbindungsmittel zur Herstellung einer Verbindung zu einem lösbaren Steckmittel mit der ersten Leiterbahn in Verbindung steht.

In der Elektroindustrie werden elektronische Geräte mit einer immer größer werdenden Funktionsdichte entwickelt, daraus ergibt sich im gleichen Maße eine steigende Packungsdichte von Kontaktelementen bei Steckverbindern, welche mit der Leiterplatte kontaktiert werden. Nach dem Stand der Technik erfolgt die Kontaktierung von Steckverbindern zu den Leiterplatten mittels Direktverbindungen, wobei Kontakte auf den Leiterplattenaußenflächen angeordnet sind und zur Kontaktierung ein Steckverbinder mit Kontaktelementen auf sie gesteckt werden kann. Bei dieser Art der Kontaktierung von Steckverbindern zu Kontakten auf der Leiterplatte ist der Packungsdichte der Kontaktelemente der Steckverbinder bzw. der Kontakte, welche auf der Leiterplatte angeordnet sind, aufgrund von beispielsweise UL-Zertifizierungen und der damit einzuhaltenen Luft- und Kriechstrecken für Ströme und den leiterplattenspezifischen Eigenschaften, damit eine Grenze gesetzt.

Nach dem Stand der Technik wird zur Einhaltung der Luft- und Kriechstrecken eine Kontaktbreite der auf den Leiterplattenaußenflächen angeordneten Kontakten soweit wie möglich reduziert, wobei dadurch eine relativ geringe Abmessung der Steckverbinder nicht erreicht werden kann.

In der EP 0 393 312 A1 ist eine mehrlagige Leiterplatte mit mindestens zwei durch eine elektrisch isolierende Zwischenschicht voneinander beabstandeten Leiterebenen offenbart.

Es ist die Aufgabe der Erfindung eine Leiterplatte anzugeben, bei welcher Verbindungsmittel angeordnet sind um bei Herstellung einer Verbindung über ein lösbares Steckmittel zu der Leiterbahn eine maximierte Packungsdichte von Verbindungsmitteln zu erreichen.

Die Aufgabe wird dadurch gelöst, dass bei der eingangs genannten Leiterplatte das Verbindungsmittel in einer Aussparung zwischen der Oberseite und der Unterseite angeordnet ist. Durch die Aussparung zwischen der Oberseite und der Unterseite der Leiterplatte wird zusätzlicher Raum geschaffen um eine Verbindung mit einer Leiterbahn der Leiterplatte zu anderen elektrischen Komponenten über Verbindungsmittel herzustellen. Konnten die Leiterbahnen der Leiterplatte zuvor nur mit Kontakten, welche jeweils an den Außenflächen der Leiterplatte angeordnet waren, mit Kontaktelementen von Steckverbindern verbunden werden, so ist es jetzt möglich, dass über Verbindungselemente, welche sich im Inneren der Leiterplatte befinden, beispielsweise in einer Zwischenschicht bei einer mehrlagigen Leiterplatte, zusätzliche Verbindungspunkte von der Leiterplatte zu einem Steckverbinder herzustellen. Die Verbindungen über einen Steckverbinder werden üblicherweise zur Kontaktierung und damit zur Signalübertragung von beispielsweise auf der Leiterplatte durch Mikroprozessoren erzeugte Signale zur Weiterleitung an ein neben der Leiterplatte angeordnetes zusätzliches Auswertesystem genutzt. Das Herstellen einer Verbindung zu dem lösbaren Steckmittel kann elektrisch oder optisch ausgeführt sein.

In einer bevorzugten Ausgestaltung ist die Aussparung derart ausgestaltet, dass durch ein Einführen des Steckmittels in die Aussparung die Verbindung hergestellt ist. Die Aussparung bildet damit ein Buchsensystem in dem das Steckmittel sicher eingeführt werden kann und vorzugsweise mit der Leiterplatte verrastet.

In einer weiter optimierten Ausgestaltung ist die Aussparung durch eine erste Grenzfläche einer ersten Schichtstruktur, eine dritte Grenzfläche einer dritten Schichtstruktur und einer zweiten Grenzfläche einer zweiten Schichtstruktur räumlich begrenzt und das Verbindungsmittel an einer der Grenzflächen angeordnet. Die Aussparung kann dabei vielerlei Formen aufweisen, vorzugsweise hat das Steckmittel eine dazu passende Form. Dabei ist das Verbindungsmittel an einer der Grenzflächen der Aussparung vorteilhafter Weise so angeordnet, dass es überein liegt mit den passenden Gegenstücken des Steckmittels und dadurch eine sichere elektrische oder optische Signalverbindung bildet.

In einer weiteren vorteilhaften Ausgestaltung sind eine Mehrzahl von Schichtstrukturen übereinander angeordnet und dadurch bilden sie ein mehrschichtiges Verbundmaterial, wobei eine Mehrzahl von Aussparungen mit einer Mehrzahl von Verbindungsmitteln zwischen den Schichtstrukturen angeordnet sind. In der mehrschichtigen Leiterplatte sind demzufolge eine Mehrzahl von Aussparungen kammartig angeordnet, so dass ein Steckmittel, beispielsweise mit einer Mehrzahl von elektrisch ausgebildeten Steckkontakten, in die Aussparungen der Leiterplatte zur Herstellung von unterschiedlichen Verbindungen gesteckt werden kann.

Bei der zuvor genannten Weiterbildung ist es vorteilhaft, dass die Aussparung in einem Randbereich angeordnet ist und ein Senkloch in einer Stirnfläche des Randes bildet.

Weiterhin ist es vorteilhaft, dass das Verbindungsmittel als eine Kontaktfläche zum Kontaktieren eines Kontaktes des als ein Stecker ausgestaltetes Steckmittel ausgestaltet ist.

Weitere Vorteile werden anhand der Zeichnung erklärt. Es zeigt:

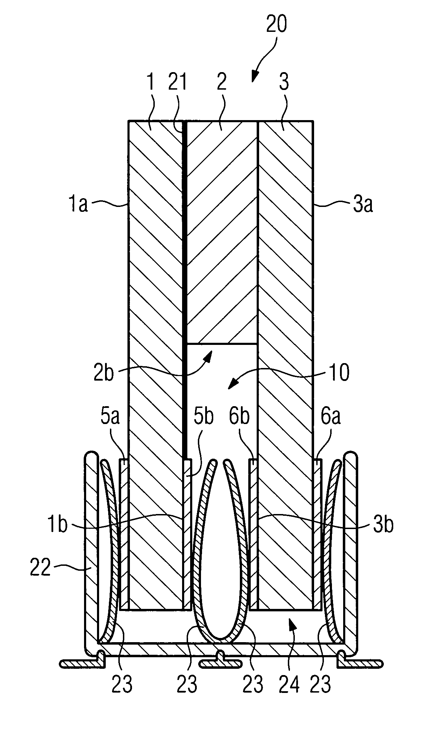

- FIG 1: einen prinzipiellen Aufbau einer Leiterplatte.

Gemäß FIG 1 ist ausschnittsweise eine Leiterplatte 20 in einer Schnittdarstellung abgebildet. Die Leiterplatte 20 weist eine erste Schichtstruktur 1 und eine dritte Schichtstruktur 3 als Außenschichten auf. Zwischen der ersten Schichtstruktur 1 und der dritten Schichtstruktur 3 ist eine zweite Schichtstruktur 2 angeordnet. Die zweite Schichtstruktur 2 wird auch als "Prepregschicht" bezeichnet. Auf einer ersten Grenzfläche 1b der ersten Schichtstruktur ist im Inneren der Leiterplatte 20 eine Leiterbahn 21 angeordnet.

Um Leiterbahnen der Leiterplatte 20 mit elektrischen Einheiten außerhalb der Leiterplatte 20 zu verbinden, wurden bisher über einen Stecker 22 mit Kontakten 23 über eine Kontaktfläche 5a, welche auf der Oberseite 1a der Leiterplatte 20 angeordnet ist, eine Verbindung hergestellt. In gleicher Weise ist auf der Unterseite 3a eine zweite Kontaktfläche 6a angeordnet, welche über die Kontakte 23 des Steckers 22 mit elektrischen Systemen, welche außerhalb der Leiterplatte angeordnet sind, Kontakt aufnehmen können.

Um eine Packungsdichte des Steckers 22 zu erhöhen, ist zwischen der Oberseite 1a und der Unterseite 3a der Leiterplatte 20 eine dritte Kontaktfläche 5b und eine vierte Kontaktfläche 6b angeordnet. Innerhalb einer Aussparung 10 sind zur Erhöhung der Packungsdichte die dritte Kontaktfläche 5b und die vierte Kontaktfläche 6b angeordnet, wobei die Aussparung 10 durch eine erste Grenzfläche 1b der ersten Schichtstruktur 1, eine dritte Grenzfläche 3b der dritten Schichtstruktur 3 und einer zweiten Grenzfläche 2b der zweiten Schichtstruktur 2 räumlich begrenzt ist, die dritte Kontaktfläche 5b ist an der ersten Grenzfläche 1b flächig angeordnet und die vierte Kontaktfläche 6b ist auf der dritten Grenzfläche 3b ebenfalls flächig angeordnet, so dass sich die beiden Kontaktflächen 5b, 6b gegenüberstehen.

Die Aussparung 10 in der Leiterplatte 20 bildet in einem Randbereich der Leiterplatte 20 innerhalb einer Stirnfläche 24 des Randes der Leiterplatte 20 ein Senkloch. Dieses Senkloch kann zylindrisch, rechteckig, quadratisch, pyramidenförmig oder konisch ausgestaltet sein.

Auf der Leiterplatte 20 untergebrachte elektronische Einheiten können über den Stecker 22 mit einer gegenüber dem Stand der Technik erhöhten Packungsdichte, nun eine größere Anzahl von Verbindungen gleichzeitig zu elektrischen Geräten aufbauen, welche nicht auf der Leiterplatte angeordnet sind. Durch die Trennung der ersten Kontaktfläche 5a mittels der ersten Schichtstruktur 1 von der dritten Kontaktfläche 5b und die damit verbundene isolierende Wirkung können die nach der UL-Zertifizierung geforderten Luft- und Kriechstruktur eingehalten werden.

Selbstverständlich kann sich die Anordnung von einer Aussparung in einer Mehrzahl von Aussparungen in einer Stirnfläche einer Leiterplatte fortsetzen, so dass ein Steckverbinder kammartig in die Stirnfläche 24 der Leiterplatte 20 gesteckt werden kann. Auch ist es denkbar, dass bei einer beispielsweise achtlagigen Leiterplatte zwischen der Oberseite und der Unterseite der achtlagigen Leiterplatte bei insgesamt vier Schichtstrukturen, welche nicht als Prepregmaterial ausgestaltet sind, drei Aussparungen zwischen diesen Schichtstrukturen für weitere Kontaktelemente anzuordnen.

## Patentansprüche

1. Leiterplatte (20) mit zumindest einer ersten Leiterbahn (21), einer flächig ausgebildeten Unterseite (3a) einer flächig ausgestalteten Oberseite (1a),
wobei ein erstes Verbindungsmittel zur Herstellung einer Verbindung zu einem lösbaren Steckmittel mit der ersten Leiterbahn (21) in Verbindung steht,
**dadurch gekennzeichnet, dass** das Verbindungsmittel in einer Aussparung (10) zwischen der Oberseite (1a) und der Unterseite (3a) angeordnet ist.

2. Leiterplatte (20) nach Anspruch 1,
wobei die Aussparung (10) derart ausgestaltet ist, dass durch ein Einführen des Steckmittels in die Aussparung (10) die Verbindung hergestellt ist.

3. Leiterplatte (20) nach Anspruch 1 oder 2,
wobei die Aussparung (10) durch eine erste Grenzfläche (1b) einer ersten Schichtstruktur (1), eine dritte Grenzfläche (3b) einer dritten Schichtstruktur (3) und einer zweiten Grenzfläche (2b) einer zweiten Schichtstruktur (2) räumlich begrenzt ist und das Verbindungsmittel an einer der Grenzflächen (1b,2b,3b) angeordnet ist.

4. Leiterplatte (20) nach Anspruch 3,
wobei eine Mehrzahl von Schichtstrukturen übereinander angeordnet sind und ein mehrschichtiges Verbundmaterial bilden,
wobei eine Mehrzahl von Aussparungen (10) mit einer Mehrzahl von Verbindungsmitteln zwischen den Schichtstrukturen angeordnet sind.

5. Leiterplatte (20) nach einem der Ansprüche 1 bis 4,
wobei die Aussparung (10) in einem Randbereich angeordnet ist und ein Senkloch in einer Stirnfläche (24) des Randes bildet.

6. Leiterplatte (20),
wobei das Verbindungsmittel als eine Kontaktfläche (5b,6b) zum Kontaktieren eines Kontaktes (23) des als ein Stecker (22) ausgestaltetes Steckmittel ausgestaltet ist.
